# EUROPEAN PATENT APPLICATION

(11) **EP 2 849 324 A2**
(43) Date of publication of application: **18.03.2015**
(21) Application number: 14182420.1
(22) Date of filing: 27.08.2014
(51) Int. Cl.: H02M 1/088, H02M 7/00

(54) **Power conversion apparatus**

(30) Priority: 17.09.2013 JP 2013192041
(71) Applicant: Kabushiki Kaisha Yaskawa Denki, Kitakyushu-shi, Fukuoka 806-0004 (JP)
(72) Inventor: Ujita, Yu, Kitakyushu-shi, Fukuoka 806-0004 (JP); Koguma, Kiyonori, Kitakyushu-shi, Fukuoka 806-0004 (JP); Yamaguchi, Yoshifumi, Kitakyushu-shi, Fukuoka 806-0004 (JP); Honda, Tomokazu, Kitakyushu-shi, Fukuoka 806-0004 (JP)
(74) Representative: Viering, Jentschura & Partner Patent- und Rechtsanwälte

(57) **Abstract**

A power conversion apparatus includes: a horizontal switching element having a front surface and a rear surface, including a first electrode and a second electrode on the front surface, and having a first current path between the first electrode and the second electrode; a snubber capacitor electrically connected to the horizontal switching element; a first substrate on which the snubber capacitor is mounted, the first substrate being connected to the first electrode and the second electrode on the front surface of the horizontal switching element; and a second current path through which an electric current flows in a direction approximately opposite to the first current path that is a path allowing an electric current to flow between the first electrode and the second electrode of the horizontal switching element, the second current path being provided in the first substrate and disposed at a position opposite to the first current path.

## Description

### BACKGROUND

### 1. Technical Field

The present disclosure relates to a power conversion apparatus.

### 2. Related Art

A power conversion apparatus has conventionally been known (for example, see JP-A-2011-67045).

The inverter apparatus (power conversion apparatus) disclosed in JP-A-2011-67045 includes a lower metal substrate and an upper dielectric substrate disposed to face each other, a MOSFET (horizontal switching element), and a snubber capacitor. The MOSFET and the snubber capacitor are disposed and held between the lower metal substrate and the upper dielectric substrate. This inverter apparatus is configured to make an electric current flow in a snubber circuit including the snubber capacitor through the lower metal substrate and the upper dielectric substrate.

However, the inverter apparatus disclosed in JP-A-2011-67045 is configured to make the electric current flow in the snubber circuit including the snubber capacitor through the lower metal substrate and the upper dielectric substrate. The configuration in this inverter apparatus makes the current path of the circuit long, resulting in a problem of an increase in wiring inductance of the snubber circuit including the snubber capacitor.

This disclosure has been made in order to solve the problem as above. An object of the present disclosure is to provide a power conversion apparatus that can reduce the wiring inductance of a snubber circuit including a snubber capacitor.

### SUMMARY

A power conversion apparatus includes: a horizontal switching element having a front surface and a rear surface, including a first electrode and a second electrode on the front surface, and having a first current path between the first electrode and the second electrode; a snubber capacitor electrically connected to the horizontal switching element; a first substrate on which the snubber capacitor is mounted, the first substrate being connected to the first electrode and the second electrode on the front surface of the horizontal switching element; and a second current path through which an electric current flows in a direction approximately opposite to the first current path that is a path allowing an electric current to flow between the first electrode and the second electrode of the horizontal switching element, the second current path being provided in the first substrate and disposed at a position opposite to the first current path.

### BRIEF DESCRIPTION OF DRAWINGS

FIG. 1 is a circuit diagram illustrating an inverter apparatus according to an embodiment;
FIG. 2 is a cross-sectional diagram illustrating the inverter apparatus according to the embodiment (sectional diagram taken along a line 150-150 of FIG. 3);
FIG. 3 is a diagram illustrating a top surface of a first substrate of the inverter apparatus according to the embodiment;
FIG. 4 is a diagram illustrating an intermediate layer of the first substrate of the inverter apparatus according to the embodiment;
FIG. 5 is a diagram illustrating a bottom surface of the first substrate of the inverter apparatus according to the embodiment;
FIG. 6 is a diagram illustrating a top surface of a second substrate of the inverter apparatus according to the embodiment;
FIG. 7 is a diagram illustrating a bottom surface of a second substrate of the inverter apparatus according to the embodiment;
FIG. 8 is a planar view of a horizontal switching element according to an embodiment viewed from the front surface side;
FIG. 9 is a planar view of the horizontal switching element according to the embodiment viewed from the rear surface side;
FIG. 10 is a planar view of a control switching element according to an embodiment viewed from the front surface thereof;
FIG. 11 is a planar view of the control switching element according to the embodiment viewed from the rear surface thereof; and
FIG. 12 is a sectional diagram (sectional diagram taken along a line 150-150 of FIG. 3) illustrating the current path of the inverter apparatus according to the embodiment.

### DETAILED DESCRIPTION

In the following detailed description, for purpose of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

A power conversion apparatus according to an aspect of the present disclosure includes: a horizontal switching element having a front surface and a rear surface, including a first electrode and a second electrode on the front surface, and having a first current path between the first electrode and the second electrode; a snubber capacitor electrically connected to the horizontal switching element; a first substrate on which the snubber capacitor is mounted, the first substrate being connected to the first electrode and the second electrode on the front surface of the horizontal switching element; and a second current path through which an electric current flows in a direction approximately opposite to the first current path that is a path allowing an electric current to flow between the first electrode and the second electrode of the horizontal switching element, the second current path being provided in the first substrate and disposed at a position opposite to the first current path.

In the power conversion apparatus according to the aspect of the present disclosure, since the first substrate includes the snubber capacitor mounted thereon and is connected to the first and second electrodes on the front surface of the horizontal switching element, an electric current can flow in the snubber circuit including the snubber capacitor only through the first substrate. Thus, for example, the current path of the snubber circuit including the snubber capacitor can be shortened as compared to the case where an electric current flows through the first substrate and a substrate other than the first substrate on the rear surface of the horizontal switching element. Therefore, a reduction in the wiring inductance of the snubber circuit including the snubber capacitor can be attained.

Further, the first substrate is configured to include a second current path. The first current path is a path allowing an electric current to flow between the first electrode and the second electrode of the horizontal switching element. In the second current path, an electric current flows in a direction approximately opposite to the first current path. The second current path is disposed at a position opposite to the first current path. Thus, the change of the magnetic flux generated in the first current path can be cancelled by the change of the magnetic flux generated in the second current path. Likewise, therefore, a reduction in the wiring inductance of the snubber circuit including the snubber capacitor can be attained.

The power conversion apparatus can reduce the wiring inductance of the snubber circuit including the snubber capacitor.

An embodiment of the present disclosure is hereinafter described with reference to the drawings.

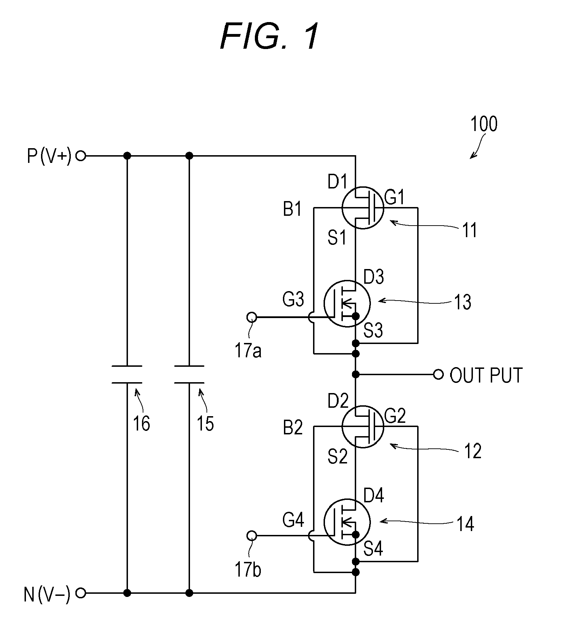

Referring now to FIG. 1, the structure of an inverter apparatus 100 according to this embodiment is described. The inverter apparatus 100 is an exemplary "power conversion apparatus".

The inverter apparatus 100 is configured to convert direct current power input from a direct current power source (not shown) through input terminals P (V+) and N (V-) into alternating current power and output the alternating current power from an output terminal.

The inverter apparatus 100 includes two horizontal switching elements 11 and 12, two control switching elements 13 and 14, which are respectively connected to the two horizontal switching elements, and snubber capacitors 15 and 16. Note that the horizontal switching elements 11 and 12 are normally-on type switching elements. In other words, when the voltage applied to a gate electrode G1 (G2) is 0 V, an electric current flows between a drain electrode D1 (D2) and a source electrode S1 (S2) in the horizontal switching elements 11 and 12. The horizontal switching element 11 is an exemplary "first horizontal switching element", and the horizontal switching element 12 is an exemplary "second horizontal switching element".

The control switching elements 13 and 14 are normally-off type switching elements. In other words, in each of the control switching elements 13 and 14, an electric current does not flow between a drain electrode D3 (D4) and a source electrode S3 (S4) when the voltage applied to a gate electrode G3 (G4) is 0 V. The control switching elements 13 and 14 are cascode-connected to the horizontal switching elements 11 and 12, respectively. Thus, an electric current flows between the drain electrode D1 (D2) and the source electrode S1 (S2) of the horizontal switching element 11 (12) while the control switching element 13 (14) is on.

Specifically, the gate electrode G1 (G2) of the horizontal switching element 11 (12) is connected to the source electrode S3 (S4) of the control switching element 13 (14). Thus, the control switching element 13 (14) is configured to control the actuation (switching operation) of the horizontal switching element 11 (12) by performing the switching operation based on a control signal input to the gate electrode G3 (G4). As a result, the switching circuit including the normally-on type horizontal switching element 11 (12) and the normally-off type control switching element 13 (14) is configured to be controlled as the normally-off type as a whole.

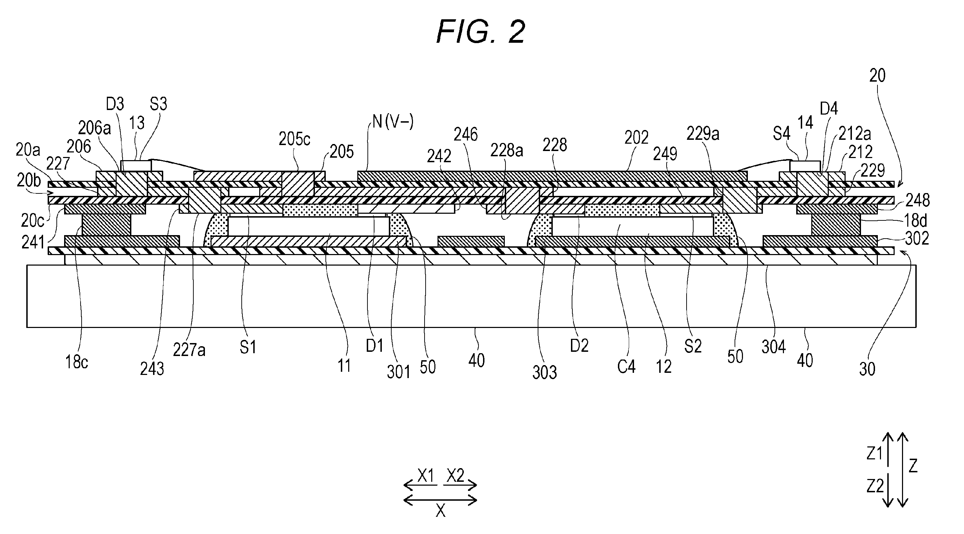

Next, the configuration (structure) of the inverter apparatus 100 according to the embodiment is specifically described with reference to FIG. 2 to FIG. 12.

As illustrated in FIG. 2 to FIG. 7, the inverter apparatus 100 includes a first substrate 20, a second substrate 30, two horizontal switching elements 11 and 12, two control switching elements 13 and 14, two snubber capacitors 15 and 16, and a heat sink 40.

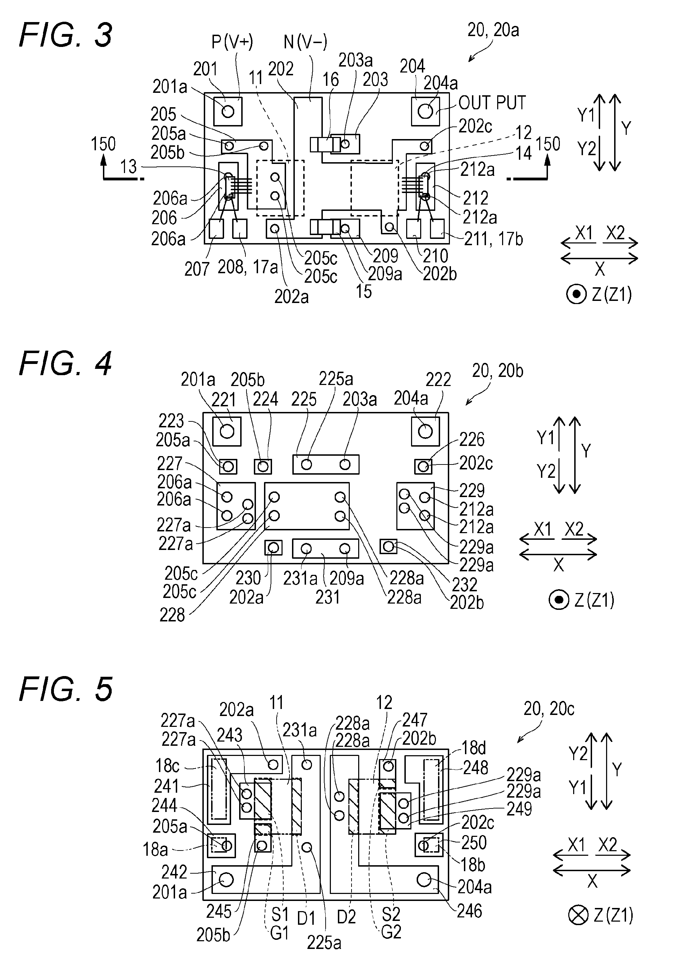

As illustrated in FIG. 2, the first substrate 20 and the second substrate 30 are vertically disposed to face each other at a predetermined distance therebetween (in the Z direction). Specifically, the first substrate 20 is disposed on the upper side (in the Z1 direction) and the second substrate 30 is disposed on the lower side (in the Z2 direction). The horizontal switching elements 11 and 12 are disposed between a bottom surface 20c of the first substrate 20 (surface in the Z2 direction) and a top surface 30a of the second substrate 30 (surface in the Z1 direction). As illustrated in FIG. 3, moreover, the control switching elements 13 and 14 and the snubber capacitors 15 and 16 are disposed on the top surface 20a of the first substrate 20. A heat conductive material 50 fills the space between the bottom surface 20c of the first substrate 20 and the top surface 30a of the second substrate 30 around the horizontal switching elements 11 and 12. Moreover, the space except the heat conductive material 50 between the bottom surface 20c of the first substrate 20 and the top surface 30a of the second substrate 30 is filled with sealing resin (not shown).

As illustrated in FIG. 3, conductive patterns 201, 202, 203, 204, 205, 206, 207, 208, 209, 210, 211, and 212 are provided on the top surface 20a of the first substrate 20. As illustrated in FIG. 4, conductive patterns 221, 222, 223, 224, 225, 226, 227, 228, 229, 230, 231, and 232 are provided in an intermediate layer 20b of the first substrate 20. Moreover, as illustrated in FIG. 5, conductive patterns 241, 242, 243, 244, 245, 246, 247, 248, 249, and 250 are provided on the bottom surface 20c of the first substrate 20.

As illustrated in FIG. 3 to FIG. 5, the conductive pattern 201 on the top surface 20a, the conductive pattern 221 on the intermediate layer 20b, and the conductive pattern 242 on the bottom surface 20c are connected to one another through a penetration electrode 201a. In addition, the conductive pattern 202 on the top surface 20a, the conductive pattern 230 on the intermediate layer 20b, and the conductive pattern 241 on the bottom surface 20c are connected to one another through a penetration electrode 202a. Further, the conductive pattern 202 on the top surface 20a, the conductive pattern 232 on the intermediate layer 20b, and the conductive pattern 247 on the bottom surface 20c are connected to one another through a penetration electrode 202b. Furthermore, the conductive pattern 202 on the top surface 20a, the conductive pattern 226 on the intermediate layer 20b, and the conductive pattern 250 on the bottom surface 20c are connected to one another through a penetration electrode 202c.

As illustrated in FIG. 3 and FIG. 4, the conductive pattern 203 on the top surface 20a and the conductive pattern 225 on the intermediate layer 20b are connected to each other through a penetration electrode 203a. As illustrated in FIG. 3 to FIG. 5, the conductive pattern 204 on the top surface 20a, the conductive pattern 222 on the intermediate layer 20b, and the conductive pattern 246 on the bottom surface 20c are connected to one another through a penetration electrode 204a. Moreover, the conductive pattern 205 on the top surface 20a, the conductive pattern 223 on the intermediate layer 20b, and the conductive pattern 244 on the bottom surface 20c are connected to one another through a penetration electrode 205a. In addition, the conductive pattern 205 on the top surface 20a, the conductive pattern 224 on the intermediate layer 20b, and the conductive pattern 245 on the bottom surface 20c are connected to one another through a penetration electrode 205b.

As illustrated in FIG. 3 and FIG. 4, the conductive pattern 205 on the top surface 20a and the conductive pattern 228 on the intermediate layer 20b are connected to each other through two penetration electrodes 205c. Further, the conductive pattern 206 on the top surface 20a and the conductive pattern 227 on the intermediate layer 20b are connected to each other through two penetration electrodes 206a. Additionally, the conductive pattern 209 on the top surface 20a and the conductive pattern 231 on the intermediate layer 20b are connected to each other through a penetration electrode 209a. Moreover, the conductive pattern 212 on the top surface 20a and the conductive pattern 229 on the intermediate layer 20b are connected to each other through two penetration electrodes 212a.

As illustrated in FIG. 4 and FIG. 5, the conductive pattern 225 on the intermediate layer 20b and the conductive pattern 242 on the bottom surface 20c are connected to each other through a penetration electrode 225a. In addition, the conductive pattern 227 on the intermediate layer 20b and the conductive pattern 243 on the bottom surface 20c are connected to each other through two penetration electrodes 227a. Further, the conductive pattern 228 on the intermediate layer 20b and the conductive pattern 246 on the bottom surface 20c are connected to each other through two penetration electrodes 228a. In addition, the conductive pattern 229 on the intermediate layer 20b and the conductive pattern 249 on the bottom surface 20c are connected to each other through two penetration electrodes 229a. Furthermore, the conductive pattern 231 on the intermediate layer 20b and the conductive pattern 242 on the bottom surface 20c are connected to each other through two penetration electrodes 231a.

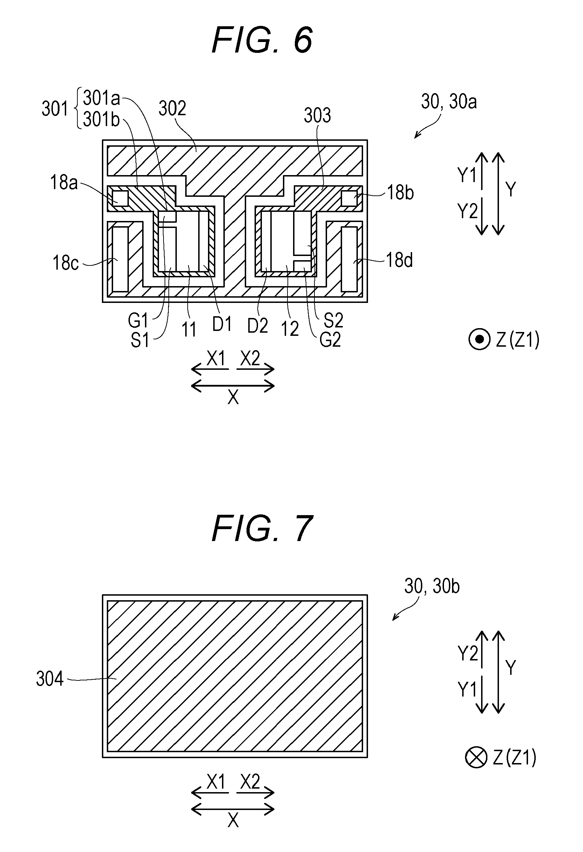

As illustrated in FIG. 6, conductive patterns 301, 302, and 303 are provided on the top surface 30a of the second substrate 30. The conductive pattern 301 includes an element-bonding pattern portion 301a, and a connection pattern portion 301b. On the element-bonding pattern portion 301a, a rear surface 11b of the horizontal switching element 11 is bonded. The connection pattern portion 301b has the element-bonding pattern portion 301a connected to the first substrate 20. As illustrated in FIG. 7, a ground pattern 304 is provided at the bottom surface 30b of the second substrate 30. The conductive pattern 301 is an example of "potential adjustment pattern".

As illustrated in FIG. 3, the conductive pattern 201 on the top surface 20a of the first substrate 20 is connected to the input terminal P (V+). The conductive pattern 202 is connected to the input terminal N (V-). The conductive pattern 204 is connected to the output terminal. The conductive pattern 208 is connected to an input terminal 17a. Through the input terminal 17a, a control signal is input to the gate electrode G3 of the control switching element 13. The conductive pattern 211 is connected to an input terminal 17b. Through the input terminal 17b, a control signal is input to the gate electrode G4 of the control switching element 14.

As illustrated in FIG. 5 and FIG. 6, the conductive pattern 244 on the bottom surface 20c of the first substrate 20 is connected to the conductive pattern 301 (connection pattern portion 301b) on the top surface 30a of the second substrate 30 through a columnar electrode 18a. Moreover, the conductive pattern 250 on the bottom surface 20c of the first substrate 20 is connected to the conductive pattern 303 on the top surface 30a of the second substrate 30 through a columnar electrode 18b. Moreover, the conductive pattern 241 on the bottom surface 20c of the first substrate 20 is connected to the conductive pattern 302 on the top surface 30a of the second substrate 30 through a columnar electrode 18c. In addition, the conductive pattern 248 on the bottom surface 20c of the first substrate 20 is connected to the conductive pattern 302 on the top surface 30a of the second substrate 30 through a columnar electrode 18d.

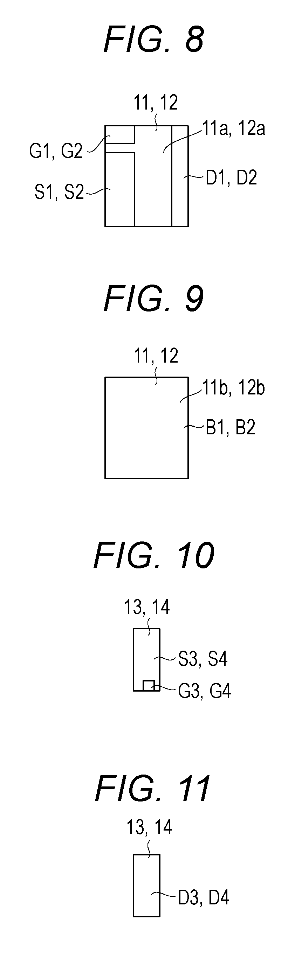

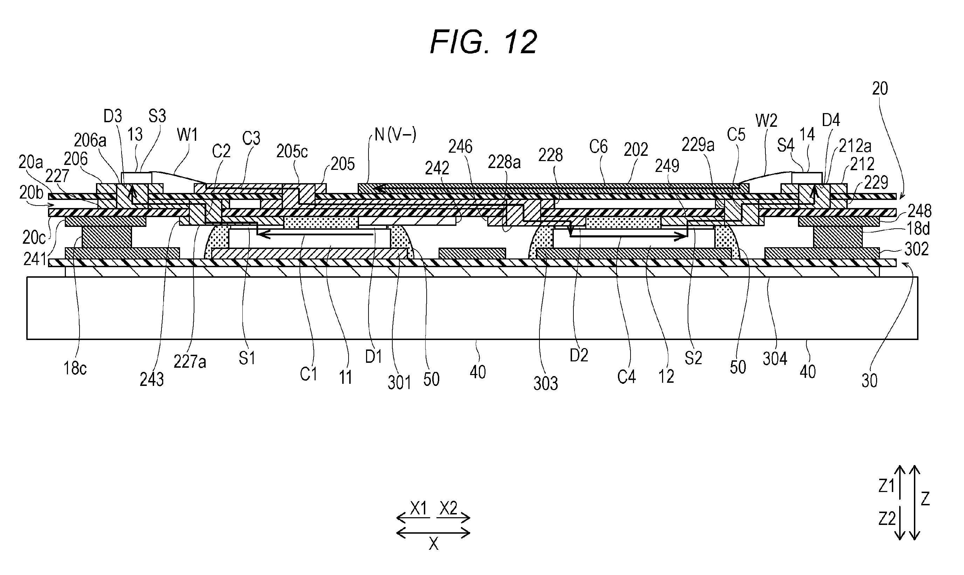

As illustrated in FIG. 8 and FIG. 9, the horizontal switching element 11 (12) has a front surface 11a (12a) and a rear surface 11b (12b). The front surface 11a (12a) of the horizontal switching element 11 (12) includes the gate electrode G1 (G2), the source electrode S1 (S2), and the drain electrode D1 (D2). In other words, in the horizontal switching element 11 (12), current mainly flows on one surface side provided with each electrode during the actuation. Therefore, the surface on the side provided with each electrode mainly generates heat. The rear surface 11b of the horizontal switching element 11 (12) is provided with a body electrode B1 (B2). As illustrated in FIG. 12, the horizontal switching element 11 (12) includes a first current path C1 (C4) between the source electrode S1 (S2) and the drain electrode D1 (D2). The first current path C1 (C4) extends in a direction parallel to the front surface 11a (12a) and the rear surface 11b (12b). The first current path C1 (C4) is a path allowing an electric current to flow between the drain electrode D1 (D2) and the source electrode S1 (S2) of the horizontal switching element 11 (12). Moreover, the first current path C1 (C4) is disposed near the front surface 11a (12a) of the horizontal switching element 11 (12). The source electrode S1 (S2) is an exemplary "first electrode", and the drain electrode D1 (D2) is an exemplary "second electrode".

The horizontal switching element 11 (12) is formed of a semiconductor material including GaN (gallium nitride). The horizontal switching elements 11 and 12 constitute an inverter circuit. The horizontal switching elements 11 and 12 are disposed so that each of the front surfaces 11a and 12a faces the first substrate 20.

Specifically, in the horizontal switching elements 11 (12), the drain electrode D1 (D2) is connected to the conductive pattern 242 (246) on the bottom surface 20c of the first substrate 20 as illustrated in FIG. 5. In the horizontal switching element 11 (12), the source electrode S1 (S2) is connected to the conductive pattern 243 (249) on the bottom surface 20c of the first substrate 20. In the horizontal switching elements 11 (12), moreover, the gate electrode G1 (G2) is connected to the conductive pattern 245 (247) on the bottom surface 20c of the first substrate 20. As illustrated in FIG. 6, in the horizontal switching element 11 (12), moreover, the body electrode B1 (B2) is connected to the conductive pattern 301 (303) on the top surface 30a of the second substrate 30.

Specifically, in the horizontal switching element 11 (12), the gate electrode G1 (G2), the source electrode S1 (S2), and the drain electrode D1 (D2) provided on the upper side (in the Z1 direction) are bonded to the conductive patterns on the bottom surface 20c of the first substrate 20 on the upper side through the bonding layer including solder or the like.

In the horizontal switching element 11, the body electrode B1 provided on the lower side (in the Z2 direction) is bonded to the element-bonding pattern portion 301a of the conductive pattern 301 of the second substrate 30 on the lower side through the bonding layer including solder or the like. In other words, in the horizontal switching element 11, the body electrode B1 on the rear surface 11b is connected to have the same potential as the output terminal. In the horizontal switching element 12, the body electrode B2 provided on the lower side (in the Z2 direction) is bonded to the conductive pattern 303 of the second substrate 30 on the lower side through the bonding layer including solder or the like. In other words, in the horizontal switching element 12, the body electrode B2 on the rear surface 12b is connected to have the same potential as the input terminal N (V-).

As illustrated in FIG. 10 and FIG. 11, the control switching element 13 (14) includes a vertical device including the gate electrode G3 (G4), the source electrode S3 (S4), and the drain electrode D3 (D4). Specifically, in the control switching element 13 (14), the gate electrode G3 (G4) and the source electrode S3 (S4) are disposed on the upper side (in the Z1 direction) and the drain electrode D3 (D4) is disposed on the lower side (in the Z2 direction). The control switching element 13 (14) is formed of the semiconductor material including silicon (Si).

Here, in this embodiment, the control switching element 13 (14) is configured to control the actuation of the horizontal switching element 11 (12). The control switching element 13 (14) is mounted on a surface (top surface 20a) of the first substrate 20, opposite to the surface (bottom surface 20c) thereof connected to the horizontal switching element 11 (12).

Moreover, as illustrated in FIG. 3, the control switching element 13 (14) is disposed on the top surface 20a (surface in the Z1 direction) of the first substrate 20. Specifically, in the control switching element 13 (14), the drain electrode D3 (D4) is connected to the conductive pattern 206 (212) on the top surface 20a of the first substrate 20 through the bonding layer including solder or the like. In the control switching element 13 (14), the each source electrode S3 (S4) is connected to the conductive patterns 205 and 207 (202 and 210) on the top surface 20a of the first substrate 20 through wires including metal such as aluminum or copper. In the control switching element 13 (14), moreover, the gate electrode G3 (G4) is connected to the conductive pattern 208 (211) on the top surface 20a of the first substrate 20 through wires including metal such as aluminum or copper.

As illustrated in FIG. 3, the control switching element 13 (14) is disposed at a position not overlapping with the horizontal switching element 11 (12) in plan view (viewed in a direction orthogonal to the plane of the first substrate 20 (from the Z direction)). In addition, the control switching element 13 (14) is disposed at a position on the side opposite to the snubber capacitors 15 and 16 relative to the horizontal switching element 11 (12) in plan view (viewed from the Z direction). In other words, the control switching element 13 (14) is disposed close to the outer periphery of the first substrate 20 relative to the horizontal switching element 11 (12) in plan view.

The snubber capacitors 15 and 16 are disposed in parallel to each other so that the respective capacitors are connected to the input terminals P (V+) and N (V-) as illustrated in FIG. 1. The snubber capacitor 15 (16) is electrically connected to the horizontal switching elements 11 and 12 and the control switching elements 13 and 14. Specifically, as illustrated in FIG. 3, the snubber capacitor 15 is disposed to connect the conductive pattern 202 and the conductive pattern 209 on the top surface 20a of the first substrate 20. The snubber capacitor 16 is disposed to connect the conductive pattern 202 and the conductive pattern 203 on the top surface 20a of the first substrate 20.

In this embodiment, the snubber capacitors 15 and 16 are mounted on the surface (top surface 20a) of the first substrate 20, opposite to the surface (bottom surface 20c) connected to the horizontal switching elements 11 and 12. The snubber capacitors 15 and 16 are disposed at the position not overlapping with the horizontal switching elements 11 and 12 in plan view (viewed from the Z direction).

As illustrated in FIG. 2, the heat sink 40 is provided to dissipate the heat generated during the operation of the horizontal switching elements 11 and 12. The heat sink 40 is disposed on the ground pattern 304 side (on the lower side (in the Z2 direction)) of the second substrate 30.

The heat conductive material 50 (see FIG. 2) is formed of, for example, epoxy resin with excellent heat conductivity.

Here, in this embodiment, as illustrated in FIG. 3, the snubber capacitors 15 and 16 are mounted on the top surface 20a of the first substrate 20. As illustrated in FIG. 5, the bottom surface 20c of the first substrate 20 is connected to the drain electrode D1 (D2), the source electrode S1 (S2), and the gate electrode G1 (G2) on the front surface 11a (12a) side of the horizontal switching element 11 (12).

In this embodiment, the first substrate 20 includes a second current path C3 (C6) as illustrated in FIG. 12. The first current path C1 (C4) is a path allowing an electric current to flow between the drain electrode D1 (D2) and the source electrode S 1 (S2) of the horizontal switching element 11 (12). In the second current path C3 (C6), an electric current flows in a direction approximately opposite to that of the first current path C1 (C4). The second current path C3 (C6) is disposed at a position opposite to the first current path C1 (C4). Specifically, the first substrate 20 includes a third current path C2 (C5), the second current path C3, and the second current path C6. The third current path C2 (C5) is a path allowing an electric current to flow between the source electrode S1 (S2) of the horizontal switching element 11 (12) and the drain electrode D3 (D4) of the control switching element 13 (14). The second current path C3 is a path allowing an electric current to flow between the source electrode S3 of the control switching element 13 and the drain electrode D2 of the horizontal switching element 12. The second current path C6 is a path allowing an electric current to flow between the source electrode S4 of the control switching element 14 and the input terminal N (V-).

The third current path C2 includes the conductive pattern 243 on the bottom surface 20c of the first substrate 20, the penetration electrode 227a, the conductive pattern 227 on the intermediate layer 20b, the penetration electrode 206a, and the conductive pattern 206 on the top surface 20a. Moreover, the second current path C3 includes the conductive pattern 205 on the top surface 20a of the first substrate 20, the penetration electrode 205c, the conductive pattern 228 on the intermediate layer 20b, the penetration electrode 228a, and the conductive pattern 246 on the bottom surface 20c.

The third current path C5 includes the conductive pattern 249 on the bottom surface 20c of the first substrate 20, the penetration electrode 229a, the conductive pattern 229 on the intermediate layer 20b, the penetration electrode 212a, and the conductive pattern 212 on the top surface 20a. The second current path C6 includes the conductive pattern 202 on the top surface 20a of the first substrate 20.

The first current path C1 (C4) of the horizontal switching element 11 (12) and the second current path C3 (C6) of the first substrate 20 are disposed close to each other so that the changes of magnetic flux that occur due to the flow of an electric current in these current paths C1 and C3 (C4 and C6) can be mutually offset. Specifically, the first current path C1 (C4) and the second current path C3 (C6) are disposed to face each other vertically (in the Z direction).

Moreover, the second current path C3 (C6) of the first substrate 20 (including wire W1 (W2) as a fourth current path) and the third current path C2 (C5) are disposed close to each other so that the changes of magnetic flux that occur due to the flow of an electric current in these current paths C3 and C2 (C6 and C5) can be mutually offset. Specifically, the second current path C3 (C6) and the third current path C2 (C5) are disposed to face each other vertically (in the Z direction).

In this embodiment, as illustrated in FIG. 2, the second substrate 30 is disposed on the side opposite to the first substrate 20 (in the Z2 direction) relative to the horizontal switching elements 11 and 12. In other words, the horizontal switching elements 11 and 12 are disposed and held between the first substrate 20 and the second substrate 30. As illustrated in FIG. 6, the conductive pattern 301 on the top surface 30a of the second substrate 30 is formed to have the area smaller than a half of the area of the ground pattern 304 on the bottom surface 30b.

The connection pattern portion 301b of the conductive pattern 301 is formed to have an area smaller than the element-bonding pattern portion 301a bonded to the rear surface 11b of the horizontal switching element 11. In other words, the conductive pattern 301 has the area obtained by adding the area of the element-bonding pattern portion 301a bonded to the horizontal switching element 11 and the minimum area of the connection pattern portion 301b required configured to connect the element-bonding pattern portion 301a to the first substrate 20. The conductive pattern 301 is formed to have the area smaller than or equal to the area twice as large as the horizontal switching element 11 in plan view (viewed from the Z direction).

In this embodiment, the effects as below can be obtained.

In this embodiment, the snubber capacitors 15 and 16 are mounted on the first substrate 20. The first substrate 20 is connected to the drain electrode D1 (D2) and the source electrode S1 (S2) on the front surface 11a (12a) side of the horizontal switching element 11 (12). Thus, the electric current flows in the snubber circuit including the snubber capacitors 15 and 16 through the first substrate 20 without having the second substrate 30 interposed between. Therefore, the electric current path of the snubber circuit including the snubber capacitors 15 and 16 can be shortened as compared to the case in which an electric current flows through the first substrate 20 and the second substrate 30 on the rear surface 11b (12b) side of the horizontal switching element 11 (12). This can reduce the wiring inductance of the snubber circuit including the snubber capacitors 15 and 16. The first substrate 20 is configured to include the second current path C3 (C6). The first current path C1 (C4) is a path allowing an electric current to flow between the drain electrode D 1 (D2) and the source electrode S 1 (S2) of the horizontal switching element 11 (12). In the second current path C3 (C6), the electric current flows in a direction approximately opposite to that of the first current path C1 (C4). The second current path C3 (C6) is disposed at a position opposite to the first current path C1 (C4). Thus, the change of the magnetic flux caused in the first current path C1 (C4) can be offset by the change of the magnetic flux caused in the second current path C3 (C6). This can reduce the wiring inductance of the snubber circuit including the snubber capacitors 15 and 16.

In the above embodiment, the control switching element 13 (14) is mounted on the surface (top surface 20a) of the first substrate 20, opposite to the surface thereof connected to the horizontal switching element 11 (12). This can suppress the conduction of heat generated in the horizontal switching element 11 (12) to the control switching element 13 (14). As a result, the deterioration in electrical characteristic of the control switching element 13 (14) due to the heat can be suppressed.

Moreover, in this embodiment, the control switching element 13 (14) is disposed at a position not overlapping with the horizontal switching element 11 (12) in plan view (viewed from the Z direction). Thus, the conduction of heat generated from the horizontal switching element 11 (12) disposed on the bottom surface 20c of the first substrate 20 to the control switching elements 13 (14) disposed on the top surface 20a of the first substrate 20 can be effectively suppressed.

In this embodiment, the control switching element 13 (14) is disposed on the side opposite to the snubber capacitor 15 (16) relative to the horizontal switching element 11 (12) in plan view (viewed from the Z direction). Thus, in plan view, the control switching element 13 (14) can be disposed outside the two horizontal switching elements 11 and 12. For this reason, in plan view, as compared to the case in which the control switching element 13 (14) is held between the two horizontal switching elements 11 and 12, the heat generated from the horizontal switching element 11 (12) can be less easily conducted to the control switching element 13 (14).

In this embodiment, the snubber capacitors 15 and 16 are mounted on the surface (top surface 20a) of the first substrate 20, opposite to the side connected to the horizontal switching element 11 (12). This can suppress the conduction of heat generated from the horizontal switching element 11 (12) to the snubber capacitors 15 and 16.

In this embodiment, the snubber capacitors 15 and 16 are disposed at a position not overlapping with the horizontal switching element 11 (12) in plan view (viewed from the Z direction). Thus, the conduction of heat generated from the horizontal switching element 11 (12) disposed on the bottom surface 20c of the first substrate 20 to the snubber capacitors 15 and 16 disposed on the top surface 20a of the first substrate 20 can be effectively suppressed.

In this embodiment, the second substrate 30 is provided with the ground pattern 304 and the conductive pattern (potential adjustment pattern) 301 connected to the rear surface 11b of the horizontal switching element 11. The ground pattern 304 is provided on the surface (bottom surface 30b) of the second substrate 30, opposite to the side bonded to the horizontal switching element 11. Moreover, the conductive pattern 301 is formed to have the area smaller than a half of the area of the ground pattern 304. This can reduce the stray capacitance (parasitic capacitance) between the ground pattern 304 and the conductive pattern 301. As a result, the occurrence of leakage of an electric current during the high-frequency operation of the horizontal switching element 11 can be suppressed.

In this embodiment, the conductive pattern 301 includes the element-bonding pattern portion 301a and the connection pattern portion 301b. The element-bonding pattern portion 301a is bonded to the rear surface 11b of the horizontal switching element 11. The connection pattern portion 301b connects the element-bonding pattern portion 301a to the first substrate 20. Furthermore, the connection pattern portion 301b is formed to have the area smaller than the element-bonding pattern portion 301a. This can minimize the area of the conductive pattern 301. As a result, the stray capacitance (parasitic capacitance) between the ground pattern 304 and the conductive pattern 301 can be reduced easily.

In this embodiment, the conductive pattern 301 is formed to have the area smaller than or equal to twice of the area of the horizontal switching element 11 in plan view (viewed from the Z direction). This can suppress the excessive increase of the area of the conductive pattern 301. As a result, the stray capacitance (parasitic capacitance) between the ground pattern 304 and the conductive pattern 301 can be easily reduced.

In this embodiment, as described above, the inverter apparatus 100 has the heat sink 40 configured to dissipate the heat generated by the horizontal switching element 11 (12) during the operation. This heat sink 40 is disposed on the ground pattern 304 side of the second substrate 30. Thus, the heat generated from the horizontal switching element 11 (12) can be dissipated toward the side opposite to the control switching element 13 (14). As a result, the conduction of the heat to the control switching element 13 (14) can be easily suppressed.

In this embodiment, the space around the horizontal switching element 11 (12) between the first substrate 20 and the second substrate 30 is filled with the heat conductive material 50. This makes it possible to conduct the heat generated from the horizontal switching element 11 (12) to the second substrate 30 disposed on the side of the first substrate 20, opposite to the side thereof provided with the control switching element 13 (14) through the heat conductive material 50. Thus, the conduction of the heat to the control switching element 13 (14) can be easily suppressed.

In this embodiment, the control switching element 13 (14) is cascode-connected to the horizontal switching element 11 (12). Thus, by performing the switching operation based on the control signal input to the gate electrode G3 (G4) of the control switching element 13 (14), the switching operation of the horizontal switching element 11 (12) can be easily controlled.

In this embodiment, furthermore, the control switching element 13 (14) includes the vertical device. This can reduce the wiring inductance between the snubber capacitors 15 and 16, and the horizontal switching element 11 (12) in the inverter apparatus 100 including the control switching element 13 (14) including the vertical device.

In this embodiment, the horizontal switching element 11 and the horizontal switching element 12 constituting the inverter circuit are disposed so that each of the front surfaces 11a and 12a thereof faces the first substrate 20. Thus, an electric current flows from the snubber capacitors 15 and 16 to the front surfaces 11a and 12a of the horizontal switching elements through the first substrate 20. Thus, the current path between the snubber capacitors 15 and 16 and the horizontal switching elements 11 and 12 can be shortened. As a result, the wiring inductance between the snubber capacitors 15 and 16 and the horizontal switching elements 11 and 12 can be reduced.

The embodiment disclosed herein should be considered as an example in every perspective and as not being restrictive. The range of the present disclosure is shown not by the description of the above embodiment but by the scope of claims and includes all the modifications within the meaning and the range equivalent to the scope of claims.

For example, the above embodiment has described the single-phase inverter apparatus as an example of the power conversion apparatus. The power conversion apparatus, however, may be other inverter apparatus (power conversion apparatus) than the single-phase inverter apparatus. For example, the power conversion apparatus may be a three-phase inverter apparatus.

Moreover, the above embodiment has described the normally-on type horizontal switching element as an example of the horizontal switching element. The horizontal switching element, however, may be a normally-off type horizontal switching element.

Further, the above embodiment has described the semiconductor material containing GaN (gallium nitride) as an example of the material of the horizontal switching element. The horizontal switching element, however, may be formed of a semiconductor material belonging to Group III-V other than GaN, or a semiconductor material belonging to Group IV such as C (diamond). Alternatively, the horizontal switching element may be formed of other semiconductor materials.

In this embodiment, the snubber capacitor and the horizontal switching element are disposed on opposite sides of the first substrate. However, the snubber capacitor and the horizontal switching element may be disposed on the same side of the first substrate.

In this embodiment, the control switching element and the horizontal switching element are disposed on opposite sides of the first substrate. However, the control switching element and the horizontal switching element may be disposed on the same side of the first substrate.

The above embodiment has described the example in which the actuation of the horizontal switching element is controlled by the control switching element. However, the actuation of the horizontal switching element may be controlled without the use of the control switching element.

The above embodiment has described the example in which the control switching element includes the vertical device. However, the control switching element may not include the vertical device.

The above embodiment has described the example in which the power conversion apparatus includes two snubber capacitors. However, the number of snubber capacitors included in the power conversion apparatus may be one or three or more.

The above embodiment has described the example in which the power conversion apparatus includes two horizontal switching elements and two control switching elements. However, the number of horizontal switching elements and control switching elements included in the power conversion apparatus may be one or three or more.

The power conversion apparatus of the present disclosure may be any of the following first to fourteenth power conversion apparatuses.

A first power conversion apparatus includes: a horizontal switching element having a front surface and a rear surface, having a first electrode and a second electrode on the front surface, and having a first current path between the first electrode and the second electrode; a snubber capacitor electrically connected to the horizontal switching element; and a first substrate on which the snubber capacitor is mounted and the first substrate is connected to the first electrode and the second electrode on the front surface of the horizontal switching element, wherein the first substrate includes a second current path through which an electric current allows in a direction approximately opposite to the first current path through which an electric current flows between the first electrode and the second electrode of the horizontal switching element, and the second current path is disposed at a position opposite to the first current path.

A second power conversion apparatus is the first power conversion apparatus further including a control switching element configured to control actuation of the horizontal switching element, wherein the control switching element is mounted on a surface of the first substrate, opposite to a surface thereof to which the horizontal switching element is connected.

A third power conversion apparatus is the second power conversion apparatus wherein the control switching element is disposed at a position not overlapping with the horizontal switching element in plan view.

A fourth power conversion apparatus is the second or third power conversion apparatus wherein the control switching element is disposed on a side opposite to the snubber capacitor relative to the horizontal switching element in plan view.

A fifth power conversion apparatus is any of the first to fourth power conversion apparatuses wherein the snubber capacitor is mounted on a surface of the first substrate, opposite to a surface thereof to which the horizontal switching element is connected.

A sixth power conversion apparatus is any of the first to fifth power conversion apparatuses wherein the snubber capacitor is disposed at a position not overlapping with the horizontal switching element in plan view.

A seventh power conversion apparatus is any of the first to sixth power conversion apparatuses further including a second substrate disposed on a side opposite to the first substrate relative to the horizontal switching element, wherein: the second substrate includes a potential adjustment pattern connected to the rear surface of the horizontal switching element, and a ground pattern provided for a surface of the second substrate, opposite to a surface thereof to which the horizontal switching element is bonded; and the potential adjustment pattern is formed to have an area smaller than a half of an area of the ground pattern.

An eighth power conversion apparatus is the seventh power conversion apparatus wherein: the potential adjustment pattern includes an element-bonding pattern portion to which the rear surface of the horizontal switching element is bonded and a connection pattern portion configured to connect the element-bonding pattern portion to the first substrate; and the connection pattern portion is formed to have an area smaller than the element-bonding pattern portion.

A ninth power conversion apparatus is the seventh or eighth power conversion apparatus wherein the potential adjustment pattern is formed to have an area smaller than or equal to the area twice as large as the horizontal switching element in plan view.

A tenth power conversion apparatus is any of the seventh to ninth power conversion apparatuses further including a heat sink configured to dissipate heat generated from the horizontal switching element, wherein the heat sink is disposed on the ground pattern side of the second substrate.

An eleventh power conversion apparatus is any of the seventh to tenth power conversion apparatuses wherein a space around the horizontal switching element between the first substrate and the second substrate is filled with a heat conductive material.

A twelfth power conversion apparatus is any of the first to eleventh power conversion apparatuses wherein the control switching element is cascode-connected to the horizontal switching element.

A thirteenth power conversion apparatus is any of the first to twelfth power conversion apparatuses wherein the control switching element includes a vertical device.

A fourteenth power conversion apparatus is any of the first to thirteenth power conversion apparatuses wherein: the horizontal switching element includes a first horizontal switching element and a second horizontal switching element constituting an inverter circuit; and the first horizontal switching element and the second horizontal switching element are disposed so that each of the front surfaces faces the first substrate.

The foregoing detailed description has been presented for the purposes of illustration and description. Many modifications and variations are possible in light of the above teaching. It is not intended to be exhaustive or to limit the subject matter described herein to the precise form disclosed. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims appended hereto.

## Claims

1. A power conversion apparatus (100) comprising:
a horizontal switching element (11, 12) having a front surface (11a, 12a) and a rear surface (11b, 12b), including a first electrode (S1, S2) and a second electrode (D1, D2) on the front surface, and having a first current path (C1, C4) between the first electrode and the second electrode;
a snubber capacitor (15, 16) electrically connected to the horizontal switching element;
a first substrate (10) on which the snubber capacitor is mounted, the first substrate (10) being connected to the first electrode and the second electrode on the front surface of the horizontal switching element; and
a second current path (C3, C6) through which an electric current flows in a direction approximately opposite to the first current path that is a path allowing an electric current to flow between the first electrode and the second electrode of the horizontal switching element, the second current path being provided in the first substrate and disposed at a position opposite to the first current path.

2. The power conversion apparatus according to Claim 1, further comprising a control switching element (13, 14) configured to control actuation of the horizontal switching element, wherein the control switching element is mounted on a surface (20a) of the first substrate, opposite to a surface thereof to which the horizontal switching element is connected.

3. The power conversion apparatus according to Claim 2, wherein the control switching element is disposed at a position not overlapping with the horizontal switching element in plan view.

4. The power conversion apparatus according to Claim 2 or 3, wherein the control switching element is disposed on a side opposite to the snubber capacitor relative to the horizontal switching element in plan view.

5. The power conversion apparatus according to any one of Claims 1 to 4, wherein the snubber capacitor is mounted on a surface (20a)of the first substrate, opposite to a surface thereof to which the horizontal switching element is connected.

6. The power conversion apparatus according to any one of Claims 1 to 5, wherein the snubber capacitor is disposed at a position not overlapping with the horizontal switching element in plan view.

7. The power conversion apparatus according to any one of Claims 1 to 6, further comprising a second substrate (30) disposed on a side opposite to the first substrate relative to the horizontal switching element, wherein:
the second substrate includes a potential adjustment pattern (301) connected to the rear surface of the horizontal switching element, and a ground pattern (304) provided for a surface (30b) of the second substrate, opposite to a surface thereof to which the horizontal switching element is bonded; and
the potential adjustment pattern is formed to have an area smaller than a half of an area of the ground pattern.

8. The power conversion apparatus according to Claim 7, wherein:
the potential adjustment pattern includes an element-bonding pattern portion (301a) to which the rear surface of the horizontal switching element is bonded and a connection pattern portion (301b) configured to connect the element-bonding pattern portion to the first substrate; and
the connection pattern portion is formed to have an area smaller than the element-bonding pattern portion.

9. The power conversion apparatus according to Claim 7 or 8, wherein the potential adjustment pattern is formed to have an area smaller than or equal to the area twice as large as the horizontal switching element in plan view.

10. The power conversion apparatus according to any one of Claims 7 to 9, further comprising a heat sink (40) configured to dissipate heat generated from the horizontal switching element, wherein the heat sink is disposed on the ground pattern side of the second substrate.

11. The power conversion apparatus according to any one of Claims 7 to 10, further comprising a heat conductive material (50) that fills a space around the horizontal switching element between the first substrate and the second substrate.

12. The power conversion apparatus according to any one of Claims 2 to 4, wherein the control switching element is cascode-connected to the horizontal switching element.

13. The power conversion apparatus according to any one of Claims 2 to 4, wherein the control switching element includes a vertical device.

14. The power conversion apparatus according to any one of Claims 2 to 4, wherein:
the horizontal switching element includes a first horizontal switching element (11) and a second horizontal switching element (12) constituting an inverter circuit; and
the first horizontal switching element and the second horizontal switching element are disposed so that each of the front surfaces faces the first substrate.
